# FASCICULE DE BREVET EUROPEEN

(11) **EP 0 635 880 B1**
(45) Date de publication et mention de la délivrance du brevet: **23.09.1998**
(21) Numéro de dépôt: 94401671.6
(22) Date de dépôt: 20.07.1994
(51) Int. Cl.: H01L 21/336, H01L 29/786

(54) **Procédé de fabrication d'un transistor en technologie silicium sur isolant**
Verfahren zur Herstellung eines Transistors in Silizium-auf-Isolator Technologie
Method of manufacturing a transistor using silicon on insulator technology

(30) Priorité: 22.07.1993 FR 9309021
(43) Date de publication de la demande: 25.01.1995
(73) Titulaire: COMMISSARIAT A L'ENERGIE ATOMIQUE, 75015 Paris (FR)
(72) Inventeur: Giffard, Benôit, F-38000 Grenoble (FR)
(74) Mandataire: Dubois-Chabert, Guy

(56) Documents cités:
- EP-A- 0 377 084
- US-A- 5 116 771
- PATENT ABSTRACTS OF JAPAN, vol. 16, no. 360 (E-1243) 4 Août 1992 & JP-A-04 113 677
- PATENT ABSTRACTS OF JAPAN, vol. 10, no. 209 (E-421) 22 Juillet 1986 & JP-A-61 048 976
- PATENT ABSTRACTS OF JAPAN, vol. 8, no. 213 (E-269) 28 Septembre 1984 & JP-A-59 099 772
- PATENT ABSTRACTS OF JAPAN, vol. 17, no. 434 (E-1412) 11 Août 1993 & JP-A-05 090 589

## Description

La présente invention a pour objet un procédé de fabrication d'un transistor MIS sur un film de silicium formé sur un isolant.

Elle s'applique en particulier dans le domaine de la fabrication de circuits intégrés MIS ou CMOS présentant une grande rapidité de fonctionnement.

La technologie silicium sur isolant connue sous l'abréviation SOI permet, par rapport aux techniques standards de réalisation des circuits sur un substrat monocristallin en silicium massif, une diminution des capacités parasites entre les zones actives et le substrat et donc un accroissement de la vitesse de fonctionnement, une augmentation de la densité d'intégration, une meilleure tenue aux hautes tensions et une faible sensibilité aux rayonnements.

Il existe différentes techniques pour former une couche mince de silicium sur un isolant. L'une des techniques fait appel à la recristallisation par laser d'une couche de silicium amorphe ou polycristallin, déposée sur un support isolant. Ce support peut être du saphir (technologie connue sous l'abréviation SOS) ou une couche d'oxyde de silicium obtenue par oxydation thermique d'un substrat de silicium monocristallin.

Une seconde technique connue sous l'abréviation BESOI (Bonded and etched SOI en terminologie anglo-saxonne) consiste à sceller deux substrats en silicium dont un au moins possède sur la surface de scellement une couche de SiO₂ obtenue par oxydation thermique puis à amincir l'un des deux substrats jusqu'à une épaisseur voulue.

Une troisième technique connue est basée sur l'implantation ionique d'oxygène ou d'azote à forte dose dans du silicium monocristallin massif qui, après recuit du substrat haute température, conduit à la formation d'une couche isolante enterrée d'oxyde ou de nitrure de silicium supportant une couche mince de silicium monocristallin. La technologie utilisant l'implantation d'ions oxygène est connue sous la terminologie SIMOX.

L'invention s'applique notamment à ces différentes techniques SOI.

L'avenir des filières SOI passe par la réduction de l'épaisseur de la couche de silicium, jusqu'à 30 nm environ, dans le canal du transistor, alors qu'elle est classiquement de 200 nm au départ sur les substrats. Le problème d'utiliser des substrats spécialement amincis pour obtenir en final une épaisseur faible est que l'ensemble de la couche est amincie, ce qui est bon pour la partie active du transistor (canal) mais entraîne de très gros problèmes pour faire accéder le courant dans les zones de source et drain du transistor, en particulier du fait que la résistance d'accès devient trop importante dans une couche si fine.

Ce problème de résistance d'accès parasite est notamment décrit dans le document (1) de Y. Omura et al., IEDM 1991, Technical Digest, 8-11 décembre 1991, p.675-678, "O.1 µm gate, ultrathin-film CMOS devices using SIMOX substrate with 80 nm thick buried oxide layer" ou encore dans le document (2) de D. Hisamoto et al., IEDM 1992, Technical Digest, 13-16 décembre 1992, p. 829-832, "Ultra-thin SOI CMOS with selective CVD tungsten for low resistance source and drain".

L'une des solutions proposée est de compenser la réduction d'épaisseur du silicium sur les zones de source et drain par une épitaxie locale de silicium en dehors de la zone active du transistor, et par conséquent dans les régions de source et drain. Malheureusement, cette étape est très difficile à réaliser et non encore industrielle.

Une autre solution consiste à utiliser un film très mince de silicium (<100 nm) et à siliciurer, sur une petite épaisseur, ce silicium dans les zones de source et drain comme décrit dans le document (3) IEEE Transactions on Electron Devices, vol. 39, N°5, Mai 1992 de Y. Yamagushi et al., "Self-aligned silicide technology for ultra-thin SIMOX MOSFET's, p. 1179-1183. Malheureusement, cette siliciuration sur une très petite épaisseur pose de gros problèmes technologiques.

La présente invention a pour objet un nouveau procédé de fabrication d'un transistor en couches minces en technologie silicium sur isolant permettant notamment de remédier à ces différents inconvénients.

A cet effet, l'invention propose d'utiliser des couches suffisamment épaisses de silicium et de n'amincir le silicium que dans le canal du transistor au moyen d'une oxydation localisée. Cette technique permet de résoudre le problème des contacts source et drain qui sont alors réalisés sur du silicium suffisamment épais. On peut se reporter à ce sujet au document Patent Abstracts of Japan vol. 17, N° 434 (E-1412), 11 août 1993, & JP-A-5 090 589. Un procédé de fabrication de transistors à couche mince est également décrit dans le document Patent Abstracts of Japan vol. 10, N° 209 (E-421), 22 juillet 1986, & JP-A-61 048 976.

D'une façon plus précise, l'invention a pour objet un procédé de fabrication selon la revendication 1.

En plus des avantages mentionnés ci-dessus, le procédé de l'invention permet grâce à l'oxydation localisée du silicium un auto-alignement de la structure, avec un canal toujours réalisé dans la zone amincie du silicium. L'utilisation de l'oxyde épais comme masque permet en effet l'auto-alignement de la source et du drain par rapport à la zone amincie du canal. En outre, la grille est formée débordante de la zone amincie ; ceci permet de réaliser, à peu de frais, une structure à grille débordante très favorable pour limiter la dégradation ou le vieillissement prématuré des transistors.

Comme indiqué précédemment, la couche mince de silicium peut être réalisée selon l'une des techniques connues SOI. De préférence, la couche mince est formée par implantation d'ion oxygène à forte dose dans un substrat en silicium monocristallin, suivie d'un recuit du substrat implanté.

En outre, le substrat de départ peut être ou non dopé par des ions de conductivité inverse de celle des source et drain.

Dans certaines applications, il est nécessaire de réaliser une implantation ionique au moins dans le canal, pour ajuster la tension de seuil.

Dans ce cas, et de façon avantageuse, le procédé de l'invention comporte, entre les étapes d'élimination de la couche épaisse d'oxyde et de réalisation de l'isolant mince de grille, les étapes suivantes :
- oxydation sacrificielle du silicium sur l'ensemble de la structure,
- implantation d'ions d'un type de conductivité inverse ou non de celui des source et drain,
- élimination de l'oxydation sacrificielle.

L'isolant de grille peut être un oxyde, un nitrure, ou un oxynitrure de silicium.

Par ailleurs, la grille peut être réalisée en métal (W, Al, TiW, TiN) en siliciure d'un métal réfractaire (WSi₂, TiSi₂) ou en silicium polycristallin dopé.

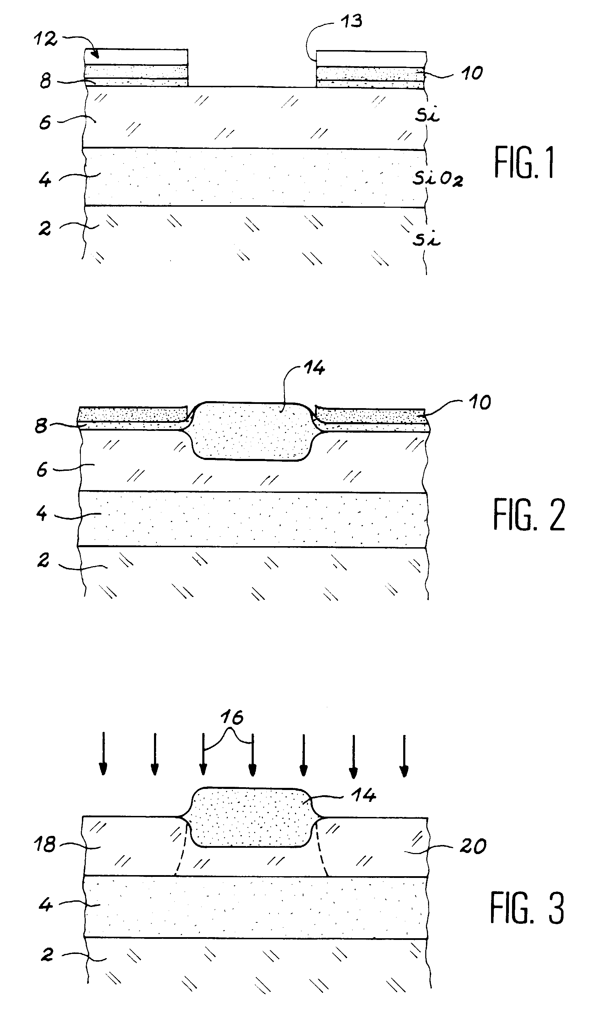

D'autres caractéristiques et avantages de l'invention ressortiront mieux de la description qui va suivre, donnée à titre illustratif et non limitatif, en référence aux figures 1 à 6 annexées illustrant schématiquement, en coupe longitudinale, les différentes étapes du procédé de fabrication conforme au premier mode de réalisation de l'invention.

La première étape consiste, comme représenté sur la figure 1, à former sur un substrat en silicium 2 monocristallin une couche d'oxyde de silicium 4 enterrée supportant une couche mince de silicium monocristallin 6 en utilisant la technique SIMOX. En particulier, cette structure silicium sur isolant est obtenue en implantant des ions d'oxygène à une dose de 10¹⁶ à quelques 10¹⁸ ions/cm² et puis en recuisant la structure implantée à une température allant de 1150°C à 1400°C.

L'implantation et le recuit peuvent être répétés plusieurs fois et l'énergie d'implantation est choisie entre 100 et 1000 keV.

A titre d'exemple, l'épaisseur de la couche 6 de Si est de l'ordre de 100 nm à 300 nm et typiquement de 200 nm et la couche 4 de SiO₂ de 400 nm.

On réalise alors un masque d'oxydation localisée. A cet effet, on réalise successivement sur le silicium 6 la croissance d'une couche d'oxyde 8 appelé oxyde piédestal qui protège la couche de Si, de 5 à 30 nm et typiquement de 13 nm d'épaisseur puis le dépôt d'une couche de nitrure de silicium 10 de 30 à 200 nm et typiquement de 80 nm. L'oxyde 8 est obtenu par oxydation thermique du film 6 et la couche 10 par dépôt chimique en phase vapeur.

On forme alors un masque de résine 12 selon les procédés classiques de photolithogravure comportant une ouverture 13 à l'emplacement prévu pour le canal du transistor MIS. Cette ouverture 13 doit être la plus petite possible, du fait du recouvrement ultérieur des source et drain par la grille et en vue d'obtenir une densité d'intégration aussi élevée que possible.

On effectue alors une gravure de la couche 10 en particulier anisotrope, par exemple du type ionique réactif en utilisant du SF₆. La couche 8 peut ou non être gravée (partiellement ou totalement) par exemple par une gravure ionique réactive de CHF₃.

On élimine ensuite, par exemple à l'aide d'un plasma d'oxygène la résine de masquage 12.

On effectue alors comme représenté sur la figure 2, une oxydation localisée de la couche 6 de silicium, conduisant à la formation d'un "LOCOS" 14 de 100 à 500 nm et typiquement de 250 nm. Il est formé en présence d'oxygène à une température de 950°C environ, le nitrure 10 gravé servant de masque à cette oxydation localisée.

On élimine ensuite les couches de nitrure et d'oxyde. La structure obtenue est alors celle représentée sur la figure 3.

On effectue alors une implantation 16 d'ions dans la couche 6 de silicium entraînant la formation de la source 18 et du drain 20 du transistor, le LOCOS 14 servant de masque à cette implantation. Cette dernière peut être de type N ou P selon la nature du transistor que l'on cherche à former.

Pour un transistor à canal N, on utilise une implantation d'arsenic ou de phosphore à une dose de 10¹⁴ à 10¹⁶ at/cm² et une énergie de 20 à 200 keV.

Pour un transistor à canal P, on effectue une implantation de bore à une dose comparable à celle utilisée pour l'implantation N et à une énergie de 10 à 150 keV.

On effectue alors l'élimination du LOCOS 14 par gravure chimique en utilisant par exemple un mélange de FH/FNH₄.

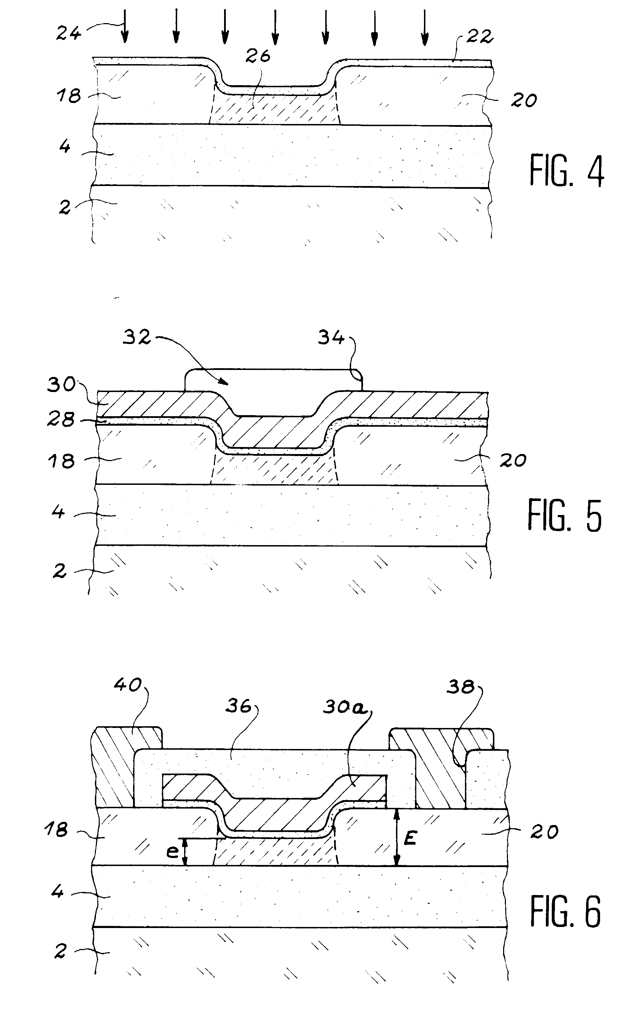

La structure obtenue est alors celle représentée sur la figure 4.

On forme alors une couche mince d'oxyde sacrificiel 22 de 20 à 60 nm et par exemple de 45 nm, par oxydation thermique de la structure dans les conditions ci-dessus, puis à travers cette couche 22, une implantation ionique 24 d'ajustement de la tension de seuil du transistor, dans le canal 26. Cette implantation 24 est réalisée sur l'ensemble de la structure.

Les ions implantés ont une conductivité soit de même type, soit inverse de celle utilisée pour l'implantation 16 suivant que l'on veut réaliser respectivement un transistor à déplétion ou un transistor à enrichissement. La dose d'implantation est en principe plus faible que celle utilisée pour l'implantation 16. Elle est choisie entre 10¹¹ et 10¹³ at/cm² et l'énergie d'implantation va de 10 à 100 keV.

On effectue ensuite l'élimination de la couche 22 d'oxyde sacrificiel par attaque chimique en utilisant un mélange de FH/FNH₄. L'utilisation de cet oxyde sacrificiel permet de protéger la surface du transistor et d'oxyder les résidus éventuels de la couche de nitrure.

On réalise alors, comme représenté sur la figure 5, l'oxyde de grille 28 de 5 à 20 nm d'épaisseur et typiquement de 12 nm sur l'ensemble de la structure par oxydation thermique de celle-ci dans les conditions ci-dessus. On dépose ensuite, par exemple selon la technique de dépôt chimique en phase vapeur une couche conductrice 30 destinée à former la grille du transistor. Cette couche est en général en silicium polycristallin dopé au phosphore (5 à 10% en volume) et présente une épaisseur de 100 à 300 nm et typiquement de 200 nm.

On forme alors un masque de gravure 32 en résine, selon les procédés classiques de photolithographie, comportant un motif 34, fixant les dimensions de la grille du transistor à réaliser.

Cette grille pouvant ne pas être auto-alignée par rapport à la source et au drain, la largeur du motif 34 du masque 32 (mesurée dans le plan des figures) est avantageusement supérieure à l'ouverture 13 du masque de résine 12 fixant l'emplacement du "LOCOS" (voir figure 5).

On effectue alors une gravure anisotrope de la couche 30, par exemple du type ionique réactif en utilisant du SF₆ pour la gravure du silicium. La couche 28 peut ou non être gravée à la suite, par une gravure par exemple ionique réactive de CHF₃ (cette gravure peut être totale ou partielle). Sur la figure 6, la couche 28 est représentée totalement gravée.

La structure obtenue après élimination de la résine de masquage est représentée sur la figure 6. On constate sur cette figure que la grille 30a du transistor déborde sur la source 18 et le drain 20.

De façon classique, on effectue alors le dépôt d'un isolant 36 par exemple en verre borosilicaté d'épaisseur supérieure à l'empilement de la grille et de l'isolant de grille, et on forme dans ce verre des trous de contact 38 pour la source, le drain ainsi que pour la grille.

Le procédé se termine par une métallisation 40 généralement en aluminium de prise de contact des source, drain et grille, que l'on grave selon le motif voulu.

Les recuits d'implantation sont effectués par des oxydations successives et/ou des recuits d'activation spécifiques, à haute température.

Dans l'exemple précis décrit ci-dessus, il reste, en fin de procédé, une épaisseur e de silicium dans le canal 26 du transistor de 45 nm environ d'épaisseur alors que l'épaisseur E de silicium dans les zones de source et drain est de 165 nm environ.

De façon plus générale, le procédé permet l'obtention d'une zone amincie de 1 à 150 nm, selon les épaisseurs de la couche de silicium d'origine, de l'épaisseur du "LOCOS" et des oxydes thermiques.

On a donc bien réalisé un amincissement du silicium dans la région du canal.

Par ailleurs, le procédé de l'invention est simple à réaliser et ne comporte aucune étape critique.

En outre, l'épaisseur obtenue au niveau des zones de source et drain est suffisante pour permettre la réalisation (si besoin est) d'une siliciuration sur ces zones afin de diminuer leur résistance électrique.

La description donnée précédemment n'a été donnée qu'à titre illustratif, des modifications pouvant être apportées par l'homme de l'art dans le cadre de l'invention telle que définie par les revendications. En particulier, il est possible de remplacer toutes les oxydations thermiques par des nitrurations thermiques, de déposer le nitrure de silicium 10 directement sur silicium sans piédestal 8, et d'effectuer l'implantation de seuil 24 à travers l'oxyde de grille 28, sans utiliser d'oxydation sacrificielle. En outre, les épaisseurs des couches peuvent être modifiées.

## Revendications

1. Procédé de fabrication d'un transistor MIS comportant une région de canal (26), une région de source (18) et une région de drain (20) de part et d'autre de la région de canal et une grille (30a) sur la région de canal, isolée des régions de source, de drain et de canal par un isolant mince (28), ce procédé comportant les étapes successives suivantes :
a) - réalisation d'une couche mince de silicium (6) sur un isolant (4),
b) - réalisation sur la couche mince de silicium (6) d'un masque (8, 10) comprenant une ouverture (13) à l'emplacement prévu pour la région de canal (26) du transistor,
c) - oxydation locale du silicium non masqué de façon à amincir localement le silicium, une couche épaisse d'oxyde (14) étant ainsi formée,
d) - élimination du masque (8,10),
e) - réalisation d'une implantation ionique (16) de source et drain dans le silicium, la couche épaisse d'oxyde (14) servant de masque à cette implantation,
f) - élimination de la couche épaisse d'oxyde (14),
g) - réalisation de l'isolant mince (28) de grille entre la région de source (18) et la région de drain (20),
h) - réalisation de la grille (30a) sur l'isolant mince (28) de grille, la grille (30a) étant réalisée débordante sur la région de source (18) et la région de drain (20).

2. Procédé selon la revendication 1, caractérisé en ce que la couche mince de silicium (6) est formée par implantation ionique d'oxygène dans un substrat en silicium monocristallin puis recuit du substrat implanté.

3. Procédé selon la revendication 1, caractérisé en ce qu'on effectue entre les étapes d'élimination de la couche épaisse d'oxyde et de réalisation de l'isolant mince de grille les étapes suivantes :
- oxydation du silicium de façon à former une couche d'oxyde sacrificiel (22),
- implantation d'ions (24) d'un type de conductivité inverse ou identique à celui des régions de source et drain (18,20),
- élimination de la couche d'oxyde sacrificiel (22).

4. Procédé selon l'une quelconque des revendications précédentes, caractérisé en ce que le silicium aminci sous la grille a une épaisseur de 1 à 150 nm.

5. Procédé selon l'une quelconque des revendications précédentes, caractérisé en ce que la grille (30a) est realisée en silicium polycristallin dopé.

## Claims

1. Method for producing a MIS transistor having a channel region (26), a source region (18) and a drain region (20) on either side of the channel region and a gate (30a) on the channel region, separated from the source, drain and channel regions by a thin insulator (28), said method involving the following successive stages:
a) producing a thin silicon film (6) on an insulator (4),
b) producing on the thin silicon film (16) a mask (8, 10) having an opening (13) at the location intended for the transistor channel region (26),
c) local oxidation of the unmasked silicon so as to locally thin the silicon, a thick oxide film (14) being formed in this way,
d) elimination of the mask (8, 10),
e) carrying out a source and drain ion implantation (16) in the silicon, the thick oxide film serving as a mask for said implantation,
f) elimination of the thick oxide film (14),
g) producing the thin gate insulator (28) between the source region (18) and the drain region (20),
h) producing the gate (30a) on the thin gate insulator (28), the gate (30a) projecting onto the source region (18) and the drain region (20).

2. Method according to claim 1, characterized in that the thin silicon film (6) is formed by ion implantation of oxygen in a monocrystalline silicon substrate, followed by annealing of the implanted substrate.

3. Method according to claim 1, characterized in that between the stages of eliminating the thick oxide layer and the production of the thin gate insulator, the following stages are performed:
- oxidation of the silicon so as to form a sacrificial oxide film (22),
- implantation of ions (24) having a conductivity the reverse or identical to that of the source and drain regions (18, 20),
- elimination of the sacrificial oxide film (22).

4. Process according to any one of the preceding claims, characterized in that the thinned silicon beneath the gate has a thickness of 1 to 150 nm.

5. Process according to any one of the preceding claims, characterized in that the gate (30a) is made from doped polycrystalline silicon.

## Patentansprüche

1. Herstellungsverfahren eines MIS-Transistors, eine Kanalzone (26) und eine Sourcezone (18) und eine Drainzone (20) zu beiden Seiten der Kanalzone umfassend, und ein Gate (30a) auf der Kanalzone, isoliert von der Source-, Drain- und Kanalzone durch einen dünnen Isolator (28), wobei dieses Verfahren folgende Schritte umfaßt:
a) - Erzeugung einer dünnen Siliciumschicht (6) auf einem Isolator (4),
b) - Bildung einer Maske (8, 10) auf der dünnen Siliciumschicht (6), wobei diese Maske an der für die Kanalzone (26) des Transistors vorgesehenen Stelle eine Öffnung (13) umfaßt,
c) - lokale Oxidation des nicht-maskierten Siliciums, wobei das Silicium lokal dünner wird und sich dabei eine dicke Oxidschicht (14) bildet,
d) - Beseitigung der Maske (8, 10),
e) - Erzeugung von Source und Drain in dem Silicium durch Ionenimplantation (16), wobei die dicke Oxidschicht (14) bei dieser Implantation als Maske dient,
f) - Beseitigung der dicken Oxidschicht (14),
g) - Erzeugung des dünnen Gate-Isolators (28) zwischen der Sourcezone (18) und der Drainzone (20),
h) - Erzeugung des Gates (30a) auf dem dünnen Isolator (28), wobei das Gate (30a) über die Sourcezone (18) und die Drainzone (20) ragt.

2. Verfahren nach Anspruch 1, dadurch gekennzeichnet, daß die dünne Siliciumschicht (6) durch Sauerstoffionenimplantation erzeugt wird, in einem Substrat aus monokristallinem Silicium, mit anschließendem Tempern des implantierten Substrats.

3. Verfahren nach Anspruch 1, dadurch gekennzeichnet, daß man zwischen den Schritten zur Beseitigung der dicken Oxidschicht und zur Erzeugung des dünnen Gate-Isolators die folgenden Schritte durchführt:
- Oxidation des Siliciums, um eine Opferoxidschicht (22) zu bilden,
- Implantation (24) von Ionen eines inversen oder identischen Konduktivitätstyps bezüglich demjenigen der Source- und der Drainzone (18,20),
- Beseitigung der Opferoxidschicht (22).

4. Verfahren nach einem der vorangehenden Ansprüche, dadurch gekennzeichnet, daß das dünner gemachte Silicium unter dem Gate eine Dicke von 1 bis 150 nm hat.

5. Verfahren nach einem der vorangehenden Ansprüche, dadurch gekennzeichnet, daß das Gate (30a) aus dotiertem polykristallinen Silicium erzeugt wird.
